# EUROPÄISCHE PATENTSCHRIFT

(11) **EP 0 835 542 B1**
(45) Veröffentlichungstag und Bekanntmachung des Hinweises auf die Patenterteilung: **20.01.1999**
(21) Anmeldenummer: 96921888.2
(22) Anmeldetag: 28.06.1996
(51) Int. Cl.: H01S 3/25, H04B 10/00, G02F 2/02

(54) **WELLENLÄNGEN-KONVERTER**
WAVELENGTH CONVERTER
CONVERTISSEUR DE LONGUEURS D'ONDE

(30) Priorität: 30.06.1995 DE 19525117
(43) Veröffentlichungstag der Anmeldung: 15.04.1998
(73) Patentinhaber: Heinrich-Hertz-Institut für Nachrichtentechnik Berlin GmbH, 10587 Berlin (DE)
(72) Erfinder: WEICH, Klaus, D-13629 Berlin (DE); EGGEMANN, Randolph, D-13593 Berlin (DE); PATZAK, Erwin, D-10625 Berlin (DE)
(74) Vertreter: Rudolph, Margit
(86) Internationale Anmeldenummer: DE9601193
(87) Internationale Veröffentlichungsnummer: WO9702634

(56) Entgegenhaltungen:
- US-A- 5 264 960
- ECOC '94. 20TH EUROPEAN CONFERENCE ON OPTICAL COMMUNICATION, PROCEEDINGS OF ECOC'94. 20TH EUROPEAN CONFERENCE ON OPTICAL COMMUNICATIONS, FIRENZE, ITALY, 25-29 SEPT. 1994, 1994, GENOVA, ITALY, IST. INT. COMUN, ITALY, Seiten 643-646 vol.2, XP002015750 WEICH K ET AL: "Injection locked laser as wavelength converter and optical regenerator up to 10 Gbit/s"
- OFC 95 OPTICAL FIBER COMMUNICATION. SUMMARIES OF PAPERS PRESENTED AT THE CONFERENCE ON OPTICAL FIBER COMMUNICATION. VOL.8. 1995 TECHNICAL DIGEST SERIES. POSTCONFERENCE EDITION, OFC 95 OPTICAL FIBER COMMUNICATION. SUMMARIES OF PAPERS PRESENTED AT TH, ISBN 0-7803-2654-7, 1995, WASHINGTON, DC, USA, OPT. SOC. AMERICA, USA, Seiten 201-202, XP002015751 BRAY M E ET AL: "Cascaded optical wavelength converters"
- OFC '95 OPTICAL FIBER COMMUNICATION. SUMMARIES OF PAPERS PRESENTED AT THE CONFERENCE ON OPTICAL FIBER COMMUNICATION. VOL.8. 1995 TECHNICAL DIGEST SERIES. POSTCONFERENCE EDITION, OFC '95 OPTICAL FIBER COMMUNICATION. SUMMARIES OF PAPERS PRESENTED AT TH, ISBN 0-7803-2654-7, 1995, WASHINGTON, DC, USA, OPT. SOC. AMERICA, USA, Seiten 71-72, XP002015752 GURIB S ET AL: "High extinction-ratio conservation up to 7.5 GBit/s in cascaded all-optical wavelength converters"

## Beschreibung

Die Erfindung betrifft einen Wellenlängen-Konverter zur Konvertierung eines ersten, zur Übertragung von Informationen dienenden Lichtsignals mit einer ersten Wellenlänge in ein zweites Lichtsignal mit einer zweiten Wellenlänge mit einem Signaleingang zur Aufnahme des ersten Lichtsignals, einem Signalausgang zur Abgabe des zweiten Lichtsignals, einem modulierbaren optischen Halbleiterverstärker mit einem Eingang, einem Ausgang und einem Modulationseingang, einer ersten Laserlichtquelle, die mit dem Halbleiterverstärker eine erste Stufe bildet, wobei der Eingang des Halbleiterverstärkers mit der ersten Laserlichtquelle und der Modulationseingang des Halbleiterverstärkers zur Kreuz-Verstärkungsmodulation mit dem Signaleingang verbunden ist und die erste Laserlichtquelle Licht einer dritten Wellenlänge emittiert, und bei dem der ersten Stufe durch ein optisches Koppelelement eine zweite Stufe nachgeschaltet ist, die eine Licht der zweiten Wellenlänge emittierende zweite Laserlichtquelle und eine modulierbare Komponente aufweist.

Wellenlängen-Konverter werden unter anderem in optischen Nachrichtenübertragungssystemen benötigt, bei denen die Daten mit dem Zeit- oder Wellenlängenmultiplexverfahren übertragen werden.

Bei einer digitalen Datenübertragung können die Daten durch Lichtsignale mit zwei verschiedenen Pegeln übertragen werden, die jeweils einem Binärsignal entsprechen. Da der Abstand zwischen den beiden logischen Pegeln bei einer Datenübertragung die Fehlerrate beeinflußt, ist es wünschenswert, daß der Pegelabstand des Eingangssignals durch die Wellenlängen-Umsetzung nicht verringert wird. Bei der Wellenlängen-Umsetzung ist der Pegelabstand durch den sogenannten Extinktionsfaktor bestimmt, wobei der Extinktionsfaktor, der mit einem einzelnen Halbleiterverstärker erreichbar ist, in der Regel zu gering ist, um im Ausgangssignal den Pegelabstand des Eingangssignals aufrechtzuerhalten. Durch die Kaskadierung zweier Halbleiterverstärker kommt es bei der Wellenlängenumsetzung zu einer zunehmenden Verschlechterung der Extinktion, d.h. zu einer Verringerung des Extinktionsfaktors.

In SIMON, J.C., et al.: Two-stages wavelength converter with improved extinction ratio, OFC 1995, San Diego, USA, ist ein zweistufiger optischer Wellenlängen-Konverter beschrieben, der die Umsetzung eines Lichtsignals von einer ersten Wellenlänge auf eine zweite Wellenlänge ermöglicht.

Der in dieser Veröffentlichung beschriebene Wellenlängen-Konverter weist zwei optische Halbleiterverstärker auf, die in Reihe geschaltet sind und jeweils ein an ihrem Eingang anliegendes Lichtsignal verstärken. Am Eingang des ersten Halbleiterverstärkers liegt das Lichtsignal einer Laserlichtquelle mit der Wellenlänge λᵢₙₜ, die im Dauerstrichbetrieb (CW - Continous wave) arbeitet, also keine Information überträgt. Weiterhin verfügen die beiden Halbleiterverstärker über einen Modulationseingang, der jeweils mit dem Signaleingang des Wellenlängen-Konverters verbunden ist.

Das am Signaleingang des Wellenlängen-Konverters anliegende Lichtsignal mit der Wellenlänge λₗₙ moduliert also die Verstärkung der beiden Halbleiterverstärker, wobei deren Verstärkungsfaktor aufgrund von Sättigungseffekten mit zunehmendem Pegel des Modulationssignals abnimmt.

Das Modulationssignal mit der Wellenlänge λₗₙ und das Lichtsignal mit der Wellenlänge kᵢₙₜ werden in entgegengesetzter Richtung in die Halbleiterverstärker eingekoppelt, so daß lediglich das Signal mit der Wellenlänge λᵢₙₜ die Halbleiterverstärker in Richtung Signalausgang verläßt.

Bei einem relativ großen Pegel des Modulationssignals mit der Wellenlänge λₗₙ werden die Halbleiterverstärker in die Sättigung getrieben, so daß der Verstärkungsfaktor und damit der Pegel des jeweiligen Ausgangssignals relativ gering ist. Weist das Modulationssignal mit der Wellenlänge λₗₙ dagegen einen relativ geringen Pegel auf, so ist der Verstärkungsfaktor der Halbleiterverstärker und damit der Pegel der jeweiligen Ausgangssignale relativ groß. Das Ausgangssignal der beiden Halbleiterverstärker weist also gegenüber dem Eingangssignal des Wellenlängen-Konverters eine invertierte Signalpolarität auf.

Zwischen den beiden Halbleiterverstärkern ist zum einen ein unidirektional wirkender optischer Isolator und zum anderen ein optisches Dämpfungsglied angeordnet. Der Isolator sperrt das aus dem Halbleiterverstärker der zweiten Stufe in Richtung der ersten Stufe austretende Licht und verhindert so eine Störung der ersten Stufe. Das Dämpfungsglied hingegen stellt den Pegel des Ausgangssignals des ersten Halbleiterverstärkers ein.

Der vorstehend beschriebene Wellenlängen-Konverter ermöglicht vorteilhaft die Umsetzung eines Lichtsignals von einer ersten Wellenlänge auf eine zweite Wellenlänge auf rein optischem Weg ohne Zwischenschaltung elektro-optischer Wandler.

Die Konvertierung ist vorteilhafterweise weitgehend unempfindlich gegen Änderungen der Polarisation und der Wellenlänge des Eingangssignals, da die Verstärkung der Halbleiterverstärker weitgehend polarisations- und wellenlängenunabhängig ist

Der erwähnte Wellenlängen-Konverter weist jedoch verschiedene Nachteile auf.

Zum einen invertiert dieser Wellenlängen-Konverter die Signalpolarität des Eingangssignals, Bei einer Kaskadierung mehrerer Wellenlängen-Konverter ist deshalb bei der Signalauswertung die Zahl der kaskadierten Wellenlängen-Konverter zu berücksichtigen, was in optischen Nachrichtenübertragungssystemen mit einem erheblichen Aufwand verbunden ist und die Flexibilität einschränkt.

Zum anderen ist die Konvertierung durch optische Halbleiterverstärker abhängig von der Lage der Wellenlängen von Eingangs- und Ausgangssignal. So funktioniert die Konvertierung mit optischen Halbleiterverstärkern am besten bei der Konvertierung von größeren zu kleineren Wellenlängen.

Weiterhin wird ein gestörtes Eingangssignal am Ausgang gestört wiedergegeben. Dies ist insbesondere bei einer Kaskadierung mehrerer Wellenlängen-Konverter nachteilig, da sich hierbei das Rauschen akkumuliert und so die Zahl der kaskadierbaren Wellenlängen-Konverter begrenzt ist.

Darüberhinaus liefert der Wellenlängen-Konverter ein Ausgangssignal mit einem relativ unreinen Frequenzspektrum ("Chirp"). Dies führt bei einer Übertragung des Ausgangssignals über einen Lichtwellenleiter aufgrund der Dispersion des Lichtwellenleiters zu einer Verzerrung des übertragenen Signals und damit zu einer Begrenzung der ohne Zwischenverstärker möglichen Übertragungsstrecke.

In US 5,264,960 ist ein Wellenlängen-Konverter beschrieben, der zweistufig aufgebaut ist, wobei jede Stufe auf dem Prinzip der Kreuz-Verstärkungsmodulation (XGM - Cross-Gain-Modulation) beruht und einen modulierbaren optischen Halbleiterverstärker mit einem Eingang, einem Ausgang und einem Modulationseingang und eine Laserlichtquelle aufweist. und die beiden Stufen durch ein optisches Koppelelement miteinander verbunden sind. Jedoch entsteht auch bei der Kaskadierung zweier XGM-Konverter ein verchirptes - und damit in der Wellenlänge unpräzises - Signal Diese spektrale Unreinheit ist aber bei der Übertragung der Signale über Standard-Einmodenfasern von Nachteil da sie eine Übertragung von 10 Gbit/s schon über eine kleine Entfernung von 20 km unmöglich macht und bereits bei niedrigen Bitraten schon deutliche Signalverzerrungen erkennbar sind (s. J.S Perino; J.M. Wiesenfeld "Proceedings of 1994 Conference on Lasers and Electro-Optics and the International Electronics Conference CLEO/IQEC. Anaheim. CA, USA. 8-13 May, pp. 298-299).

Der Erfindung liegt deshalb insbesondere die Aufgabe zugrunde, einen Wellenlängen-Konverter der eingangs genannten Art zu schaffen der eine Umsetzung der Wellenlängen mit hoher Präzision, im wesentlichen störungsfrei und mit hohem Extinktionsfaktor ermöglicht.

Diese Aufgabe wird dadurch gelöst, daß in einem Wellenlängen-Konverter der eingangs erwähnten Art erfindungsgemäß die modulierbare Komponente der zweiten Stufe einen Fabry-Perot-Laser aufweist mit einem Eingang für die zweite Laserlichtquelle, die Licht der zweiten Wellenlänge in den Fabry-Perot-Laser einstrahlt, mit einem Ausgang und einem Modulationseingang, wobei der Ausgang des Fabry-Perot-Lasers mit dem Signalausgang und der Modulationseingang des Fabry-Perot-Lasers mit dem Ausgang des Halbleiterverstärkers verbunden ist, und das Koppelelement mindestens einen Zirkulator aufweist.

Bei dem erfindungsgemäßen zweistufigen Wellenlängen-Konverter besteht die erste Stufe im wesentlichen aus einem optischen Halbleiterverstärker mit einem Eingang, einem Ausgang und einem Modulationseingang. Am Eingang des Halbleiterverstärkers liegt das Lichtsignal einer im Dauerstrichbetrieb (CW - Continuous wave) arbeitenden ersten Laserlichtquelle der Wellenlänge λᵢₙₜ an.
Der Modulationseingang des Halbleiterverstärkers ist mit dem Signaleingang des Wellenlängen-Konverters verbunden.

Das am Signaleingang des Wellenlängen-Konverters anliegende Lichtsignal moduliert also das Lichtsignal des ersten Lasers mit der Wellenlänge λᵢₙₜ. Die Modulation erfolgt hierbei durch Kreuz-Verstärkungs-Modulation.

Die Kreuz-Verstärkungs-Modulation beruht auf der Abhängigkeit des Verstärkungsfaktors vom Eingangspegel. So nimmt der Verstärkungsfaktor mit zunehmendem Pegel des Modulationssignals ab. da der Verstärker in die Sättigung gerät. Ist der Pegel des Modulationssignals relativ hoch, so ist der Verstärkungsfaktor und damit der Pegel des Ausgangssignals mit der Wellenlänge λᵢₙₜ relativ gering. Bei einem relativ geringen Pegel des Modulationssignals ist der Verstärkungsfaktor und damit der Pegel des Ausgangssignals mit der Wellenlänge λᵢₙₜ dagegen relativ hoch. Das Ausgangssignal des Halbleiterverstärkers weist also gegenüber dem Modulationssignal eine invertierte Signalpolarität auf.

Der optische Halbleiterverstärker liefert weitgehend unabhängig von der Wellenlänge und der Polarisation des Eingangssignals ein Ausgangssignal mit einer bestimmten Wellenlänge λᵢₙₜ und einer bestimmten Polarisation. Der Wellenlängen-Konverter ist deshalb weitgehend unempfindlich gegenüber Schwankungen der Polarisation oder Änderungen der Wellenlänge des Eingangssignals und somit eingangsseitig sehr flexibel.

Bei einer bevorzugten Ausführungsform sind der Modulationseingang und der Ausgang des Halbleiterverstärkers auf der einen Seite und der Eingang auf der gegenüberliegenden Seite des Halbleiterverstärkers angeordnet. Das Modulationssignal und das CW-Lichtsignal des ersten Lasers werden also aus unterschiedlichen Richtungen in den Halbleiterverstärker eingekoppelt. Den Halbleiterverstärker verläßt deshalb vorwiegend Licht mit der Wellenlänge λᵢₙₜ des ersten Lasers, während das vom Signaleingang des Wellenlängen-Konverters kommende und am Modulationseingang in den Halbleiterverstärker eintretende Licht der Wellenlänge λₗₙ kaum in Richtung zweiter Stufe weitergeführt wird. Dies ist wichtig, damit das Eingangssignal der ersten Stufe mit der Wellenlänge λₗₙ nicht deren Ausgangssignal mit der Wellenlänge λᵢₙₜ störend überlagert.
Bei dieser Ausführungsform und einer genügend hohen Entspiegelung des Verstärkers kann die Wellenlänge λₗₙ des Eingangssignals gleich der Wellenlänge λᵢₙₜ des Lasers sein, da das am Eingang des Wellenlängen-Konverters anliegende Lichtsignal den Halbleiterverstärker aufgrund der Anordnung von Modulationseingang und Ausgang nicht verlassen kann.

Bei einer anderen Ausführung ist zu demselben Zweck hinter dem Ausgang des Halbleiterverstärkers ein Filter angeordnet, das Licht mit der Wellenlänge λₗₙ sperrt.

Die zweite Stufe des Wellenlängen-Konverters besteht aus einem Fabry-Perot-Laser und einer bei der Wellenlänge λ_{Out} Licht emittierenden Laserlichtquelle. In den Fabry-Perot-Laser wird das CW-Lichtsignal dieser zweiten Laserlichtquelle mit der Wellenlänge λ_{Out} und das den Halbleiterverstärker verlassende Licht mit der Wellenlänge λᵢₙₜ über das Koppelelement eingestrahlt und führt durch "injektionsgelocktes" Schalten zu einer Modulation der Strahlung mit der Wellenlänge λ_{Out}. Bei Einstrahlen eines Datenpulses geht der Fabry-Perot-Laser von einem auf die Wellenlänge λ_{Out} eingerasteten Zustand über in einen nichteingerasteten Zustand (invertierende Modulation) oder umgekehrt (nichtinvertierende Modulation).

Über die Betriebsbedingungen der zweiten Stufe kann wahlweise - wie bereits erwähnt - invertierende oder nichtinvertierende Modulation eingestellt werden.

Durch eine zweimalige Invertierung zum einen durch den Halbleiterverstärker und zum anderen durch den Fabry-Perot-Laser der zweiten Stufe weist das Ausgangssignal die gleiche Signalpolarität auf wie das Eingangssignal des Wellenlängen-Konverters. Dies ist insbesondere bei der Kaskadierung mehrerer Wellenlängen-Konverter wichtig, da andernfalls bei einer Invertierung der Signalpolarität durch den Wellenlängen-Konverter für die Signalauswertung die Zahl der kaskadierten Wellenlängen-Konverter berücksichtigt werden müßte.

Die Übertragungsfunktion der zweiten Stufe ist aufgrund der Verwendung einer Laserlichtquelle als Umsetzer stark nichtlinear, ähnlich einem Schwellwertglied. Bei einer digitalen Datenübertragung mit zwei logischen Pegeln entsprechend den beiden Binärsignalen weist das Ausgangssignal des Wellenlängen-Konverters deshalb weitgehend unabhängig von Störungen im Eingangssignal der zweiten Stufe klar definierte Pegel auf. Dies führt zum einen zu erhöhter Flexibilität hinsichtlich der Anforderungen an die erste Stufe und zum anderen zu einer Regeneration des Eingangssignals durch den Wellenlängen-Konverter So wird auch ein von relativ starkem Rauschen überlagertes Eingangssignal korrekt und mit klar definierten Ausgangspegeln umgesetzt. Die Regenerierung des Eingangssignals ermöglicht vorteilhaft die Kaskadierung zahireicher Wellenlängen-Konverter

Der Wellenlängen-Konverter setzt also ein an seinem Signaleingang anliegendes Lichtsignal der Wellenlänge λₗₙ zunächst in der ersten Stufe auf die interne Wellenlänge λᵢₙₜ und anschließend in der zweiten Stufe auf die Ausgangswellenlänge λ_{Out} um

In einer besonderes vorteilhaften Ausgestaltung der Erfindung ist die Wellenlänge des Lasers in der zweiten Stufe abstimmbar Auf diese Weise kann der Wellenlängen-Konverter verschiedene Ausgangskanäle mit jeweils unterschiedlichen Wellenlängen adressieren.

In einer weiteren Ausgestaltung der Erfindung ist die interne Wellenlänge λᵢₙₜ zum einen kleiner als die Wellenlänge λₗₙ des Eingangssignals und zum anderen kleiner als die Wellenlänge λ_{Out} des Ausgangssignals. Hierbei wird vorteilhaft die Tatsache ausgenutzt, daß die zweite Stufe mit der Laserlichtquelle als Wellenlängen-Umsetzer relativ gut in der Lage ist, ein Lichtsignal von einer kleineren in eine größere Wellenlänge umzusetzen, während der Halbleiterverstärker ein Lichtsignal besser von größeren in eine kleinere Wellenlänge umsetzen kann. Die zweite Stufe kompensiert also den Frequenzgang der ersten Stufe Die interne Wellenlänge λᵢₙₜ wird deshalb so gewählt, daß der Halbleiterverstärker bei der vorgegebenen Wellenlänge λₗₙ des Eingangssignals optimal arbeitet.

Die Laserlichtquelle der zweiten Stufe liefert ein Lichtsignal mit einem relativ schmalbandigen Frequenzspektrum. Bei einer Übertragung über Lichtwellenleiter wird das Ausgangssignal des Wellenlängen-Konverters deshalb trotz der in Lichtwellenleitern auftretenden Dispersion nur relativ gering verzerrt, was vorteilhaft eine Übertragung über relativ große Strecken ohne Zwischenverstärker ("Repeater") ermöglicht.

Darüberhinaus liefert der Laser der zweiten Stufe auch bei einem Eingangssignal des Wellenlängen-Konverters mit einer relativ geringen spektralen Reinheit ("Chirp") ein relativ schmalbandiges Ausgangssignal. Ein durch "Chirp" beeinträchtigtes Eingangssignal wird also durch den Wellenlängen-Konverter regeneriert. Dies senkt bei einer Datenübertragung vorteilhaft die Fehlerrate bzw. vergrößert die mögliche Länge der Übertragungsstrecke und ermöglicht eine Kaskadierung zahlreicher Wellenlängen-Konverter.

Weiterhin ist der Halbleiterverstärker - wie bereits vorstehend beschrieben - weitgehend unabhängig von der Wellenlänge des Eingangssignals. Der erfindungsgemäße Wellenlängen-Konverter kann deshalb mehrere Eingangskanäle mit verschiedenen Wellenlängen erfassen. Die Wellenlängenabhängigkeit des Extinktionsfaktors ist dabei vorteilhafterweise relativ gering, was unter anderem durch die Laserlichtquelle als Umsetzer in der zweiten Stufe erreicht wird.

In einer besonderen Variante der Erfindung von eigener schutzwürdiger Bedeutung besteht das Koppelelement zur Verbindung der beiden Stufen des Wellenlängen-Konverters im wesentlichen aus einem 4-Tor-Zirkulator, der mit dem Signaleingang des Wellenlängen-Konverters, dem Modulationseingang und dem Ausgang des Halbleiterverstärkers, dem Modulationseingang und dem Ausgang des Lasers der zweiten Stufe sowie dem Signalausgang des Wellenlängen-Konverters verbunden ist.

Der Zirkulator koppelt Licht vom Signaleingang des Wellenlängen-Konverters in den Modulationseingang des Halbleiterverstärkers, vom Ausgang des Halbleiterverstärkers in den Modulationseingang des Lasers der zweiten Stufe sowie vom Ausgang der zweiten Stufe in den Signalausgang des Wellenlängen-Konverters ein. Ein derartiger Zirkulator sorgt zum einen für eine optische Isolation der beiden Stufen des Wellenlängen-Konverters und weist zum anderen vorteilhaft eine relativ geringe Einfügedämpfung von weniger als 1 dB auf.

In einer anderen Variante der Erfindung besteht das Koppelelement aus zwei hintereinandergeschalteten Zirkulatoren, wobei der erste Zirkulator mit dem Signaleingang des Wellenlängen-Konverters sowie dem Modulationseingang und dem Ausgang des Halbleiterverstärkers verbunden ist. Der zweite Zirkulator ist dagegen mit dem Modulationseingang und dem Ausgang des Lasers der zweiten Stufe sowie mit dem Signalausgang des Wellenlängen-Konverters verbunden.

Der erste Zirkulator koppelt Licht aus dem Signaleingang des Wellenlängen-Konverters in den Modulationseingang des Halbleiterverstärkers und vom Ausgang des Halbleiterverstärkers in den zweiten Zirkulator ein. Der zweite Zirkulator koppelt dann das aus dem ersten Zirkulator kommende Licht in der zweiten Stufe in den Modulationseingang des Lasers ein und führt das Ausgangssignal der zweiten Stufe zum Signalausgang des Wellenlängen-Konverters. In dieser Variante sind 3-Tor-Zirkulatoren einsetzbar. Vorteilhaft ist hierbei die große Flexibilität, da zwischen die beiden Zirkulatoren weitere Komponenten. z.B. optische Verstärker, geschaltet werden können.

Bei einer anderen bevorzugten Ausführungsform weist das optische Koppelelement herkömmliche Koppler auf, die beispielsweise als 3dB-Richtkoppler ausgeführt sind.

Der erfindungsgemäße Wellenlängen-Konverter verbindet also die Vorteile eines optischen Halbleiterverstärkers als Eingangsstufe (Polarisations- und Wellenlängenunabhängigkeit, Erfassung mehrerer Eingangskanäle mit verschiedenen Wellenlängen) mit den Vorteilen eines Laser-Konverters als Ausgangsstufe (Regenerierung des Eingangssignals durch schwellwertähnliche Übertragungsfunktion, hohes Extinktionsverhältnis des Ausgangssignals. Reinheit des Ausgangsspektrums, gleich gute Umsetzung zu größeren wie zu kleineren Wellenlängen hin) und ermöglicht, die Datenrate über einen großen Bereich frei zu wählen.

Vorteilhafterweise ist der erfindungsgemäße Wellenlängen-Konverter als hybrider Aufbau mit Einzelkomponenten oder als optoelektronische integrierte Schaltung auf einem Chip ausgeführt, jedoch sind auch andere Bauarten möglich.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:
- Figur 1: als bevorzugtes Ausführungsbeispiel der Erfindung einen Wellenlängen-Konverter mit einem 4-Tor-Zirkulator als Blockschaltbild,
- Figur 2: ein weiteres Ausführungsbeispiel der Erfindung mit zwei 3-Tor-Zirkulatoren als Blockschaltbild sowie
- Figur 3: eine schematische funktionale Darstellung der erfindungsgemäßen Wellenlängen-Umsetzung.

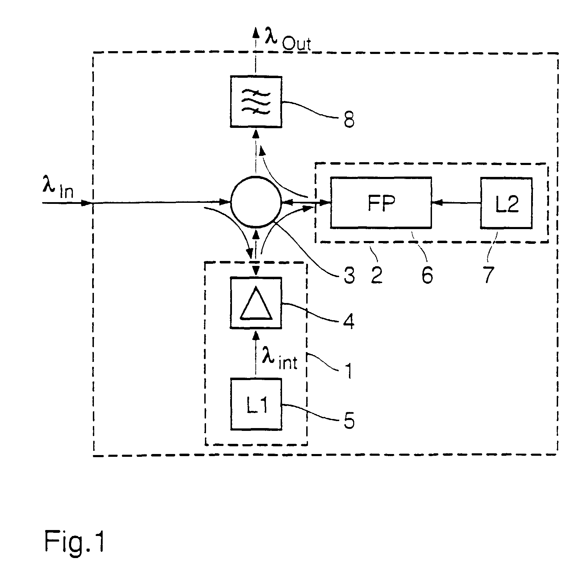

Der in Figur 1 dargestellte Wellenlängen-Konverter ermöglicht die Umsetzung eines Lichtsignals mit der Wellenlänge λₗₙ auf die Wellenlänge λ_{Out} Er eignet sich insbesondere zum Einsatz in optischen Nachrichtenübertragungssystemen mit Lichtwellenleitern, bei denen zur Optimierung der Übertragungsrate Wellenlängen- und Zeitmultiplexverfahren angewendet werden.

Der Wellenlängen-Konverter besteht aus zwei Stufen **1, 2,** die durch einen optischen 4-Tor-Zirkulator **3** miteinander verbunden sind.

Zum einen koppelt der 4-Tor-Zirkulator **3** das am Signaleingang des Wellenlängen-Konverters anliegende Lichtsignal mit der Wellenlänge λₗₙ in die erste Stufe **1** ein. Zum anderen verbindet der 4-Tor-Zirkulator **3** die beiden Stufen **1, 2** miteinander und führt das Ausgangssignal der ersten Stufe **1** der zweiten Stufe **2** zu. Weiterhin leitet der Zirkulator **3** das Ausgangssignal der zweiten Stufe **2** zum Signalausgang des Wellenlängen-Konverters weiter

Die erste Stufe **1** setzt das am Signaleingang des Wellenlängen-Konverters anliegende Lichtsignal zunächst in die interne Wellenlänge λᵢₙₜ um, während die zweite Stufe **2** dieses Lichtsignal mit der Wellenlänge λᵢₙₜ dann auf die Ausgangswellenlänge λ_{Out} umsetzt.

Die erste Stufe **1** besteht im wesentlichen aus einem optischen Halbleiterverstärker **4**, dem von der einen Seite die Strahlung einer Laserlichtquelle **5** (nachfolgend kurz "Laser" genannt) mit der Wellenlänge λᵢₙₜ und von der anderen Seite das am Signaleingang des Wellenlängen-Konverters anliegende Lichtsignal mit der Wellenlänge λₗₙ zugeführt wird. Da der Ausgang des Halbleiterverstärkers **4** auf der Seite liegt, auf der das Eingangssignal mit der Wellenlänge λₗₙ zugeführt wird. verläßt den Halbleiterverstärker **4** vorwiegend ein Lichtsignal mit der Wellenlänge λᵢₙₜ während das Eingangssignal mit der Wellenlänge λₗₙ lediglich zur Modulation dient und den Halbleiterverstärker **4** kaum in Richtung zweiter Stufe verläßt.

Die Modulation des Halbleiterverstärkers **4** erfolgt durch Kreuz-Verstärkungs-Modulation. Die Kreuz-Verstarkungs-Modulation beruht auf der Abhängigkeit des Verstärkungsfaktors vom Eingangspegel des Halbleiterverstärkers **4**. So nimmt der Verstärkungsfaktor mit zunehmendem Eingangspegel ab, da der Halbleiterverstärker **4** in die Sättigung getrieben wird.

Liegt nun am Eingang des Wellenlängen-Konverters ein Lichtsignal der Wellenlänge λₗₙ mit einem relativ starken Pegel, so führt dies aufgrund der Sättigung des Halbleiterverstärkers **4** zu einer relativ geringen Verstärkung und damit zu einem entsprechend geringen Pegel des Ausgangssignals mit der Wellenlänge λᵢₙₜ.

Weist das Eingangssignal des Wellenlängen-Konverters dagegen einen relativ geringen Pegel auf, so hat der Halbleiterverstärker **4** einen relativ großen Verstärkungsfaktor, was entsprechend am Ausgang des Halbleiterverstärkers **4** zu einem relativ hohen Pegel führt.

Am Ausgang des Halbleiterverstärkers **4** erscheint also ein Lichtsignal der Wellenlänge λᵢₙₜ, das durch das Eingangssignal moduliert wird und gegenüber diesem eine invertierte Signalpolarität aufweist.

Der Halbleiterverstärker **4** ist weitgehend unempfindlich gegen Schwankungen der Polarisation und der Wellenlänge des Eingangssignals. liefert aber ein Ausgangssignal mit konstanter Wellenlänge λᵢₙₜ und Polarisation. Der Wellenlängen-Konverter ist deshalb eingangsseitig sehr flexibel und stellt geringe Anforderungen an die Konstanz der Polarisation und der Wellenlänge des Eingangssignals. Der Wellenlängen-Konverter kann deshalb verschiedene Eingangskanäle mit unterschiedlichen Wellenlängen erfassen.

Das Ausgangssignal des Halbleiterverstärkers **4** wird durch den 4-Tor-Zirkulator 3 als Modulationssignal dem Fabry-Perot-Laser **6** zugeführt, in den CW-Licht der Wellenlänge λ_{Out} von einer weiteren Laserlichtquelle **7** eingestrahlt wird. In Abhängigkeit vom Pegel des Moduiationssignals mit der Wellenlänge λᵢₙₜ wird der Fabry-Perot-Laser **6** durch das sogenannte "injection-locking" entweder auf die Wellenlänge λᵢₙₜ oder auf die Wellenlänge λ_{Out} der Laserlichtquelle **7** eingerastet.

Weist das Ausgangssignal des Halbleiterverstärkers **4** einen hohen Pegel auf, so wird der Fabry-Perot-Laser **6** auf die Wellenlänge λᵢₙₜ "gelockt". bei einem geringen Pegel des Ausgangssignals des Halbleiterverstärkers **4** wird der Fabry-Perot-Laser **6** dagegen auf die Wellenlänge λ_{Out} der Laserlichtquelle **7** "gelockt".

Die beiden Signale mit den Wellenlängen λᵢₙₜ und λ_{Out} werden vom **4**-Tor-Zirkulator **3** einem Filter **8** zugeführt, das Licht mit der Wellenlänge λᵢₙₜ sperrt.

Das Ausgangssignal des Wellenlängen-Konverters weist also einen relativ großen Pegel auf, wenn der Fabry-Perot-Laser **6** auf die Wellenlänge λ_{Out} der Laserlichtquelle **7** "gelockt" ist, also bei einem relativ geringen Pegel des Ausgangssignals des Halbleiterverstärkers **4**. Entsprechend weist das Ausgangssignal des Wellenlängen-Konverters bei einem relativ großen Pegel des Ausgangssignals des Halbleiterverstärkers **4** einen relativ kleinen Pegel auf.

Die zweite Stufe invertiert die Signalpolarität also ein zweites Mal, so daß das Ausgangssignal und das Eingangssignal des Wellenlängen-Konverters die gleiche Signalpolarität aufweisen. Dies ermöglicht die Kaskadierung des Wellenlängen-Konverters, da andernfalls bei einer Invertierung der Signalpolarität durch den Wellenlängen-Konverter bei der Signalauswertung die Zahl der kaskadierten Wellenlängen-Konverter berücksichtigt werden müßte.

Die Wellenlängenumsetzung erfolgt in der zweiten Stufe relativ hart mit einer stark nichtlinearen Übertragungsfunktion, ähnlich einem Schwellwertglied. Bei der Übertragung von digitalen Signalen mit jeweils einem Pegel für die beiden binären Signale wird deshalb der Abstand zwischen den beiden logischen Pegeln verbessert und damit die Bit-Fehlerrate gesenkt bzw. die maximal mögliche Übertragungsstrecke vergrößert. Die zweite Stufe **2** mit dem Fabry-Perot-Laser **6** regeneriert also das Eingangssignal. Dies ermöglicht wiederum die Kaskadierung zahlreicher Wellenlängen-Konverter, da das Signal in jedem Wellenlängen-Konverter wieder aufgefrischt wird und sich somit kein Rauschen akkumulieren kann.

Darüberhinaus ermöglicht die zweite Stufe eine Umsetzung des Eingangssignals auf verschiedene Wellenlängen λ_{Out}. Hierzu muß lediglich die Laserlichtquelle **7** anders abgestimmt werden. was zu einer Anregung anderer Moden des Fabry-Perot-Lasers **6** führt. Die Zahl möglicher Emissionsfrequenzen wird allein durch den Abstimmbereich der Laserlichtquelle **7** begrenzt, der für frequenzabstimmbare Laserdioden bis zu 15 nm beträgt. Da der Modenabstand des Fabry-Perot-Lasers **6** 0.7 nm beträgt, kann der Wellenlängen-Konverter entsprechend 21 Kanäle adressieren. Hierdurch und durch Veränderung der Laser-Temperatur um weniger als 3 bis 4 °C kann im Prinzip jede gewünschte Ausgangswellenlänge λ_{Out} innerhalb des Abstimmbereichs eingestellt werden.

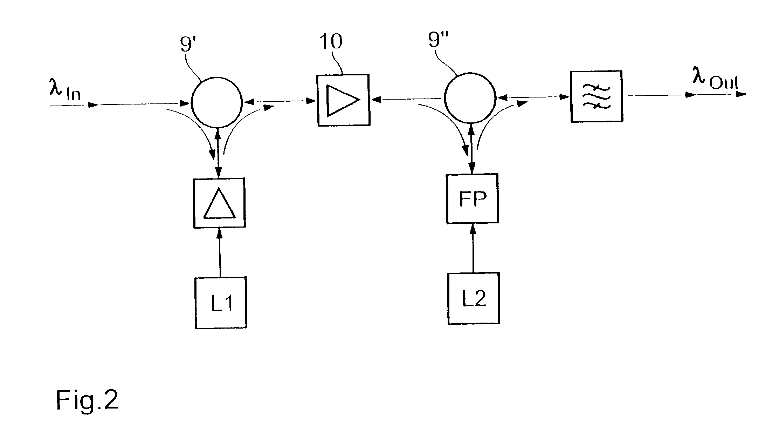

In Figur 2 sind anstelle des 4-Tor-Zirkulators - bei ansonsten gleichen Komponenten und deren gleichen Funktionen wie in Figur **1** - zwei 3-Tor-Zirkulatoren **9'**, **9"** geschaltet. Zwischen den beiden 3-Tor-Zirkulatoren **9'**, **9"** ist ein optischer Verstärker **10** angeordnet, der einen flexibleren Einsatz des Wellenlängen-Konverters ermöglicht.

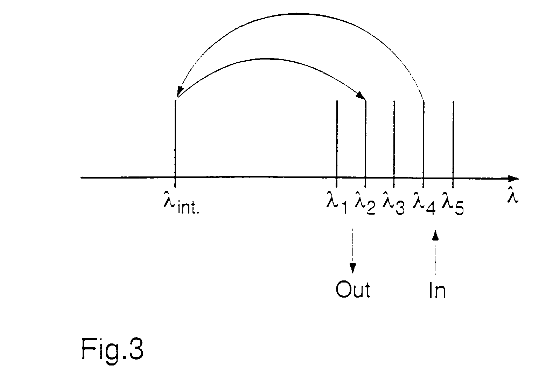

Das in Figur 3 dargestellte Schema verdeutlicht die Wellenlängen-Umsetzung des erfindungsgemäßen Wellenlängen-Konverters.

Die erste Stufe des Wellenlängen-Konverters ist wegen der Verwendung eines optischen Halbleiterverstärker relativ unabhängig von der Wellenlänge und der Polarisation des Eingangssignals. Der Wellenlängen-Konverter kann deshalb Eingangskanäle mit verschiedenen Wellenlängen λ₁ bis λ₅ erfassen. Die erste Stufe setzt das Eingangssignal dann unabhängig von seiner Wellenlänge zunächst auf die interne Wellenlänge λᵢₙₜ um. Da der Halbleiterverstärker wesentlich besser zu kleineren als zu größeren Wellenlängen hin umsetzen kann, ist die Wellenlänge λᵢₙₜ so gewählt, daß das Umsetzverhalten des Halbleiterverstärkers optimal ist. Die interne Wellenlänge λᵢₙₜ ist hierbei bestimmt durch die Wellenlänge des mit dem Halbleiterverstärker verbundenen Lasers.

Die zweite Stufe setzt dann das Ausgangssignal der ersten Stufe mit der Wellenlänge λᵢₙₜ in die Ausgangswellenlänge λ₁, λ₂, λ₃, λ₄ oder λ₅ um, die bestimmt ist durch die Wellenlänge der Laserlichtquelle der zweiten Stufe. Durch Abstimmung der Wellenlänge dieser Laserlichtquelle können also verschiedene Ausgangskanäle einschließlich λₗₙ = λ_{Out} adressiert werden.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

## Patentansprüche

1. Wellenlängen-Konverter zur Konvertierung eines ersten, zur Übertragung von Informationen dienenden Lichtsignals mit einer ersten Wellenlänge (λₗₙ) in ein zweites Lichtsignal mit einer zweiten Wellenlänge (λ_{Out}), mit einem Signaleingang zur Aufnahme des ersten Lichtsignals. einem Signalausgang zur Abgabe des zweiten Lichtsignals. einem modulierbaren optischen Halbleiterverstärker (4) mit einem Eingang, einem Ausgang und einem Modulationseingang, einer ersten Laserlichtquelle (L1), die mit dem Halbleiterverstärker (4) eine erste Stufe (1) bildet. wobei der Eingang des Halbleiterverstärkers (4) mit der ersten Laserlichtquelle (L1) und der Modulationseingang des Halbleiterverstärkers (4) zur Kreuz-Verstärkungsmodulation mit dem Signaleingang verbunden ist und die erste Laserlichtquelle (L1) Licht einer dritten Wellenlänge (λᵢₙₜ) emittiert, und bei dem der ersten Stufe (1) durch ein optisches Koppelelement eine zweite Stufe (2) nachgeschaltet ist, die eine Licht der zweiten Wellenläge (λ_{Out}) emittierende zweite Laserlichtquelle (L2) und eine modulierbare Komponente aufweist,
**dadurch gekennzeichnet,** daß
die modulierbare Komponente der zweiten Stufe (2) einen Fabry-Perot-Laser (FP) aufweist mit einem Eingang für die zweite Laserlichtquelle (L2), die Licht der zweiten Wellenlänge (λ_{Out}) in den Fabry-Perot-Laser (FP) einstrahlt, mit einem Ausgang und einem Modulationseingang, wobei der Ausgang des Fabry-Perot-Lasers (FP) mit dem Signalausgang und der Modulationseingang des Fabry-Perot-Lasers (FP) mit dem Ausgang des Halbleiterverstärkers (4) verbunden ist, und das Koppelelement mindestens einen Zirkulator aufweist.

2. Wellenlängen-Konverter nach Anspruch 1,
**dadurch gekennzeichnet,**daß
das Ausgangssignal des Halbleiterverstärkers (4) den Fabry-Perot-Laser (FP) durch Injection-Locking moduliert.

3. Wellenlängen-Konverter nach Anspruch **1** oder 2,
**dadurch gekennzeichnet,** daß
die dritte Wellenlänge (λᵢₙₜ) des Halbleiterverstärkers (4) kleiner ist als die erste Wellenlänge (λₗₙ) und die zweite Wellenlänge (λ_{Out}), so daß durch die erste Stufe (1) eine Verringerung und durch die zweite Stufe (2) eine Heraufsetzung der Wellenlänge erfolgt.

4. Wellenlängen-Konverter nach einem der Ansprüche 1 bis 3,
**dadurch gekennzeichnet,** daß
der zweiten Stufe (2) ein Filter (8) nachgeschaltet ist, das Licht mit der dritten Wellenlänge (λᵢₙₜ) sperrt.

5. Wellenlängen-Konverter nach Anspruch 1
**dadurch gekennzeichnet** daß
das Koppelelement einen Zirkulator (3) mit vier Anschlüssen aufweist. wobei der erste Anschluß mit dem Signaleingang, der zweite Anschluß mit dem Ausgang und dem Modulationseingang des Halbleiterverstärkers (4), der dritte Anschluß mit dem Modulationseingang und dem Ausgang der zweiten Stufe (2) und der vierte Anschluß mit dem Signalausgang verbunden ist, wobei der Zirkulator (3) Licht vom ersten zum zweiten, vom zweiten zum dritten und vom dritten zum vierten Anschluß führt.

6. Wellenlängen-Konverter nach Anspruch 1,
**dadurch gekennzeichnet,** daß
das Koppelelement zwei Zirkulatoren (9', 9") mit jeweils drei Anschlüssen aufweist. wobei der dritte Anschluß des ersten Zirkulators (9') mit dem ersten Anschluß des zweiten Zirkulators (9") verbunden ist, daß bei dem ersten Zirkulator (9') der erste Anschluß mit dem Signaleingang und der zweite Anschluß mit dem Ausgang und dem Modulationseingang des Halbleiterverstärkers verbunden ist, daß bei dem zweiten Zirkulator (9") der zweite Anschluß mit dem Ausgang und dem Modulationseingang der zweiten Stufe und der dritte Anschluß mit dem Signalausgang verbunden ist, daß die beiden Zirkulatoren (9', 9") jeweils Licht vom ersten zum zweiten und vom zweiten zum dritten Anschluß führen.

7. Wellenlängen-Konverter nach Anspruch 1,
**dadurch gekennzeichnet,** daß
die erste Laserlichtquelle (5) zur Optimierung des Konversionsverhaltens des Halbleiterverstärkers (4) abstimmbar ist.

8. Wellenlängen-Konverter nach Anspruch 1,
**dadurch gekennzeichnet,** daß
die zweite Laserlichtquelle (7) zur Adressierung mehrerer Ausgangskanäle abstimmbar ist.

9. Wellenlängen-Konverter nach Anspruch 1,
**dadurch gekennzeichnet,** daß
zur Sperrung des ersten Licntsignals bei dem Halbleiterverstärker (4) der Ausgang und der Modulationseingang einerseits und der Eingang andererseits auf gegenüberliegenden Seiten des Halbleiterverstärkers angeordnet sind

## Claims

1. Wavelength converter for converting a first light signal of a first wavelength (λₗₙ) serving to transmit data into a second light signal of a second wavelength (λ_{Out}), with a signal input for receiving the first light signal, a signal output for emitting the second light signal, a modulatable optical semiconductor amplifier (4) with an input, an output and a modulation input, a first laser light source (L1) forming a first stage (1) with the semiconductor amplifier (4), whereby the input of the semiconductor amplifier (4) is connected with the first laser light source (L1) and the modulation input of the semiconductor amplifier (4), for cross amplification modulation, is connected to the signal input and the first laser source (L1) emits light of the third wavelength (λᵢₙₜ), and in which a second stage (2) is connected to the output of the first stage (1) by a coupling element, the second stage (2) being provided with a second laser light source (L2) emitting light of the second wavelength (λ_{Out}) and with a modulatable component,
characterized by the fact that
the modulatable component of the second stage (2) is provided with a Fabry-Perot laser (FP) having an input for the second laser light source (L2) feeding light of the second wavelength (λ_{Out}) into the Fabry-Perot laser (FP), an output and a modulation input, whereby the output of the Fabry-Perot laser (FP) is connected to the signal output and the modulation input of the Fabry-Perot laser (FP) is connected to the output of the semiconductor amplifier (4) and the coupling element is provided with at least one circulator.

2. Wavelength converter according to claim 1,
characterized by the fact that
the output signal of the semiconductor amplifier (4) modulates the Fabry-Perot laser (FP) by injection locking.

3. Wavelength converter according to claim **1** or 2,
characterized by the fact that
the third wavelength (λᵢₙₜ) of the semiconductor amplifier (4) is shorter than the first wavelength (λₗₙ) and the second wavelength (λ_{Out}) so that a reduction of the wavelength is performed by the first stage (1) and an increase of the wavelength is performed by the second stage (2).

4. Wavelength converter according to one of claims **1** to 3,
characterized by the fact that
a filter (8) blocking light of the third wavelength (λᵢₙₜ) is connected to the output of the second stage (2).

5. Wavelenght converter according to claim 1,
characterized by the fact that
the coupling element is provided with a circulator (3) having four connections, the first connection being connected to the signal input, the second connection being connected to the output and to the modulation input of the semiconductor amplifier (4), the third connection being connected to the modulation input and the output of the second stage (2) and the forth connection being connected to the signal output, whereby the circulator (3) feeds light from the first to the second connection, from the second to the third connection, and from the third to the fourth connection.

6. Wavelength converter according to claim 1,
characterized by the fact that
the coupling element is provided with two circulators (9', 9") each having three connections, whereby the third connection of the first circulator (9') is connected to the first connection of the second circulator (9"), that at the first circulator (9') the first connection is connected to the signal input and the second connection is connected to the output and to the modulation input of the semiconductor amplifier, that at the second circulator (9") the second connection is connected to the output and to the modulation input of the second stage and the third connection is connected to the signal output, that each of the two circulators (9', 9") feed light from the first to the second and from the second to the third connection.

7. Wavelength converter according to claim 1,
characterized by the fact
that for optimizing the conversion performance of the semiconductor amplifier (4) the first laser light source (5) is tuneable.

8. Wavelength converter according to claim 1,
characterized by the fact
that the second laser light source (7) is tuneable for addressing a plurality of output channels.

9. Wavelength converter according to claim 1,
characterized by the fact that
for blocking the first light signal the output and the modulation input on the one hand and the input on the other hand of the semiconductor amplifier (4) are arranged on opposite sides of the semiconductor amplifier.

## Revendications

1. Convertisseur de longueur d'onde, pour la conversion d'un premier signal lumineux servant à la transmission d'informations et présentant une première longueur d'onde (λₗₙ) en un deuxième signal lumineux présentant une deuxième longueur d'onde (λₒᵤₜ), comportant une entrée de signal pour la réception du premier signal lumineux, une sortie de signal pour l'émission du deuxième signal lumineux, un amplificateur optique modulable à semi-conducteurs (4) comportant une entrée, une sortie et une entrée de modulation, une première source de lumière laser (L1) qui forme un premier étage (1) avec l'amplificateur à semi-conducteurs (4), l'entrée de l'amplificateur à semi-conducteurs (4) étant reliée à la première source de lumière laser (L1) et l'entrée de modulation de l'amplificateur à semi-conducteurs (4) étant reliée à l'entrée de signal en vue d'une modulation croisée de l'amplification, et la première source de lumière laser (L1) émettant de la lumière présentant une troisième longueur d'onde (λᵢₙₜ), et dans lequel le premier étage (1) est raccordé par l'intermédiaire d'un élément d'accouplement optique à un deuxième étage (2) aval qui présente une deuxième source de lumière laser (L2) émettant une lumière présentant la deuxième longueur d'onde (λ_{Out}) ainsi qu'un composant modulable, caractérisé en ce que le composant modulable du deuxième étage (2) présente un laser de Fabry-Perot (FP) comportant une entrée pour la deuxième source de lumière laser (L2) qui projette de la lumière présentant la deuxième longueur d'onde (λ_{Out}) dans le laser de Fabry-Perot (FP), une sortie et une entrée de modulation, la sortie du laser de Fabry-Perot (FP) étant reliée à la sortie de signal, et l'entrée de modulation du laser de Fabry-Perot (FP) étant reliée à la sortie de l'amplificateur à semi-conducteurs (4), et l'élément d'accouplement présente au moins un circulateur.

2. Convertisseur de longueur d'onde selon la revendication 1, caractérisé en ce que la sortie de signal de l'amplificateur à semi-conducteurs (4) module le laser de Fabry-Perot (FP) par verrouillage d'injection.

3. Convertisseur de longueur d'onde selon les revendications 1 ou 2, caractérisé en ce que la troisième longueur d'onde (λᵢₙₜ) de l'amplificateur à semi-conducteurs (4) est inférieure à la première longueur d'onde (λₗₙ) et à la deuxième longueur d'onde (λₒᵤₜ), de sorte que le premier étage réalise une diminution de la longueur d'onde et que le deuxième étage (2) rehausse la longueur d'onde.

4. Convertisseur de longueur d'onde selon l'une des revendications 1 à 3, caractérisé en ce qu'en aval du deuxième étage (2) est connecté un filtre (8) qui arrête la lumière présentant la troisième longueur d'onde (λᵢₙₜ),

5. Convertisseur de longueur d'onde selon la revendication 1, caractérisé en ce que l'élément d'accouplement présente un circulateur (3) doté de quatre raccordements, le premier raccordement étant relié à l'entrée de signal, le deuxième raccordement à la sortie et à l'entrée de modulation de l'amplificateur à semi-conducteurs (4), le troisième raccordement à l'entrée de modulation et à la sortie du deuxième étage (2) et le quatrième raccordement à la sortie de signal, le circulateur (3) conduisant la lumière du premier au deuxième raccordement, du deuxième au troisième raccordement et du troisième au quatrième raccordement.

6. Convertisseur de longueur d'onde selon la revendication 1, caractérisé en ce que l'élément d'accouplement présente deux circulateurs (9', 9"), comportant chacun trois raccordements, le troisième raccordement du premier circulateur (9') étant relié au premier raccordement du deuxième circulateur (9"), en ce que sur le premier circulateur (9'), le premier raccordement est relié à l'entrée de signal et le deuxième raccordement à la sortie et à l'entrée de modulation de l'amplificateur à semi-conducteurs, en ce que sur le deuxième circulateur (9"), le deuxième raccordement est raccordé à la sortie et à l'entrée de modulation du deuxième étage et le troisième raccordement est relié à la sortie de signal, en ce que les deux circulateurs (9', 9") conduisent la lumière respectivement du premier au deuxième raccordement et du deuxième au troisième raccordement.

7. Convertisseur de longueur d'onde selon la revendication 1, caractérisé en ce que la première source de lumière laser (7) peut être accordée en vue d'optimiser la conversion de l'amplificateur à semi-conducteurs (4).

8. Convertisseur de longueur d'onde selon la revendication 1, caractérisé en ce que la deuxième source de lumière laser (7) peut être accordée pour adresser plusieurs canaux de sortie.

9. Convertisseur de longueur d'onde selon la revendication 1, caractérisé en ce que pour arrêter le premier signal lumineux sur l'amplificateur à semi-conducteurs (4), la sortie et l'entrée de modulation, d'une part, et l'entrée, d'autre part, sont disposées sur des côtés opposés de l'amplificateur à semi-conducteurs.
